Europäisches Patentamt

European Patent Office

Office européen des brevets

(19)

(11) Veröffentlichungsnummer: **0 140 112**
**B1**

(12) **EUROPÄISCHE PATENTSCHRIFT**

(45) Veröffentlichungstag der Patentschrift: **02.01.91**

(51) Int. Cl.⁵: **H 05 K 3/22**

(21) Anmeldenummer: **84111012.5**

(22) Anmeldetag: **14.09.84**

(54) **Verfahren und Einrichtung zum Durchtrennen von Leiterbahnstegen.**

(30) Priorität: **30.09.83 DE 3335578**

(43) Veröffentlichungstag der Anmeldung:
**08.05.85 Patentblatt 85/19**

(45) Bekanntmachung des Hinweises auf die
Patenterteilung:
**02.01.91 Patentblatt 91/01**

(84) Benannte Vertragsstaaten:
**AT BE CH DE FR GB IT LI NL SE**

(56) Entgegenhaltungen:
**EP-A-0 043 586**
**FR-A-2 466 173**

**IBM TECHNICAL DISCLOSURE BULLETIN, Band
24, Nr. 12, May 1982, Seiten 6383-6384, IBM
Corp, New York, US; J. FUNARI et al.: "Printed
circuit deletion using capacitor discharge"**

(73) Patentinhaber: **Siemens Aktiengesellschaft
Wittelsbacherplatz 2
D-8000 München 2 (DE)**

(72) Erfinder: **Thorwarth, Rüdiger
Tillystrasse 4
D-8019 Glonn (DE)**
Erfinder: **Dederer, Günter, Dipl.-Ing. (FH) ·
Wotanstrasse 12
D-8034 Germering (DE)**

## Beschreibung

Die Erfindung betrifft eine Einrichtung zum Durchtrennen von Leiterbahnstegen nach dem Oberbegriff des Anspruchs 1.

Eine derartige Einrichtung, bei welcher die Elektroden unmittelbar auf die jeweiligen Anschlußflächen aufgesetzt werden, ist aus der FR-A-2 466 173 bekannt. Eine ähnliche Einrichtung, bei welcher die Elektroden jedoch direkt auf die durchzutrennenden Leiterbahnstege aufgesetzt werden, ist aus der US-Zeitschrift IBM Technical Disclosure Bulletin, Band 24, Nr. 12, Mai 1982, Seiten 6383, 6384 bekannt.

Bei Leiterplatten müssen häufig nachträgliche Verbindungsänderungen hergestellt werden. Aus diesem Grund sind auf den Außenlagen der Leiterplatten jeweils zwei gegenüberliegende Anschlußflächen durch einen Leiterbahnsteg miteinander verbunden, wobei je nach Ausführung der Leiterplatte in eine Anschlußfläche ein Wrapstift eingelötet sein kann. Die Anschlußfläche oder der Wrapstift sind dabei als Stützpunkt für eine spätere Änderungsverdrahtung vorgesehen. Ist dann eine Änderung notwendig, so wird der entsprechende Leiterbahnsteg durchgetrennt. Für das Trennen durch elektrische Widerstandserwärmung werden Einrichtungen der eingangs genannten Art eingesetzt. Bei Anschlußflächen mit eingelöteten Wrapstiften erfolgt das Trennen auch häufig durch mechanisches Entfernen der Leiterbahnstege, beispielsweise durch Abschaben mit Hilfe eines Spezialwerkzeuges. Ein mechanisches Trennen durch Bohren oder Fräsen ist ebenfalls möglich. Bedingt durch die manuelle Tätigkeit besteht dabei jedoch die Gefahr, daß die Leiterbahnstege nicht vollständig durchgetrennt werden oder daß daneben- oder darunterliegende Leiterbahnen beschädigt werden.

Der Erfindung liegt die Aufgabe zugrunde, eine Einrichtung der eingangs genannten Art so zu verbessern, daß auch eine einwandfreie Kontaktierung von mit Wrapstiften versehenen Anschlußflächen möglich ist.

Diese Aufgabe wird bei einer gattungsgemäßen Einrichtung durch die kennzeichnenden Merkmale des Anspruchs 1 gelöst.

Durch die erfindungsgemäße Ausgestaltung einer Elektrode als Zangenelektrode kann diese Zangenelektrode dann gegen die zugeordnete Anschlußfläche gedrückt werden oder einen aus der Anschlußfläche führenden Wrapstift fassen. Insbesondere kann dann auch mindestens eine Elektrode um die als Zangenelektrode ausgebildete Elektrode drehbar sein. Nach der Kontaktierung eines Wrapstiftes durch die Zangenelektrode können dann durch Drehen der gesamten Einrichtung um die Zangenelektrode in beliebiger Richtung von der Anschlußfläche wegführende Leiterbahnstege durch die andere Elektrode erfaßt werden.

Weiterhin ist es vorteilhaft, wenn die Elektroden unabhängig voneinander heb- und senkbar sind. Hierdurch wird eine sichere Kontaktierung der Anschlußflächen oder eines Wrapstiftes ermöglicht. Außerdem können dann bei einer nicht drehbaren Einrichtung mit insgesamt drei Elektroden je nach Lage der beiden Anschlußflächen die mittlere Elektrode und die eine äußere Elektrode oder die mittlere Elektrode und die andere äußere Elektrode zur Kontaktierung der zugeordneten Anschlußflächen bzw. Wrapstifte abgesenkt werden. Dies ist besonders dann vorteilhaft, wenn die durchzutrennenden Leiterbahnstege teils nach einer und dann wieder nach der anderen Seite angeordnet sind und ein Drehen der gesamten Leiterplatte vermieden werden soll.

Gemäß einer weiteren vorteilhaften Ausgestaltung der erfindungsgemäßen Einrichtung ist in mindestens eine Elektrode ein Zuführkanal für eine Schutzflüssigkeit eingebracht. Über diesen Zuführkanal kann dann auf einfache Weise die Schutzflüssigkeit in den Bereich der Trennstelle geleitet werden.

Der Trennbereich wird vor dem Durchtrennen des Leiterbahnsteges mit der Schutzflüssigkeit benetzt. Diese Schutzflüssigkeit bindet dann beim Trennvorgang entstehende Metallpartikel und schützt die freigelegte Oberfläche der Leiterplatte vor einem möglichen Niederschlag der beim Widerstandsdurchbrennen freigesetzten Stoffe. Außerdem müssen bei Verwendung einer Schutzflüssigkeit die Elektroden weniger häufig gereinigt werden.

Ein Ausführungsbeispiel der Erfindung ist in der Zeichnung dargestellt und wird im folgenden näher beschrieben.

Es zeigen:

Figur 1 eine prinzipielle Darstellung des Widerstandsdurchbrennens von Leiterbahnstegen,

Figur 2 einen durch Widerstandsdurchbrennen in einem Leiterbahnsteg erzeugten Trennspalt und

Figur 3 eine Einrichtung zum Widerstandsdurchbrennen von Leiterbahnstegen in stark vereinfachter schematischer Darstellung.

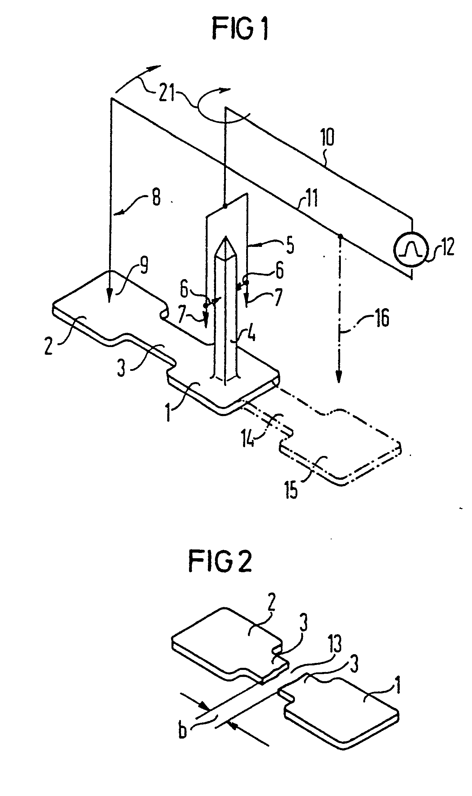

Figur 1 zeigt auf der Außenlage einer nicht näher dargestellten Leiterplatte angeordnete Anschlußflächen 1 und 2, die durch einen Leiterbahnsteg 3 elektrisch leitend miteinander verbunden sind. In die erste Anschlußfläche 1 ist ein im Querschnitt quadratischer Wrapstift 4 eingelötet, der als Stützpunkt für eine mögliche Änderungsverdrahtung vorgesehen ist. Ist eine derartige Änderung notwendig, so muß der Leiterbahnsteg 3 durchgetrennt werden. Hierzu kontaktiert eine erste Elektrode 5 den Wrapstift 4, wobei diese Kontaktierung in der Zeichnung durch zwei Pfeile 6 angedeutet ist. Für den Fall, daß kein Wrapstift 4 vorhanden ist und die erste Anschlußfläche 1 direkt als Stützpunkt für eine Änderungsverdrahtung dient, kann die erste Elektrode 5 die erste Anschlußfläche 1 auch direkt kontaktieren, was in der Zeichnung durch zwei Pfeile 7 angedeutet ist. Die zweite Anschlußfläche 2 wird mit Hilfe einer zweiten Elektrode 8 kontaktiert, wobei diese Kontaktierung in der Zeichnung durch einen Pfeil 9 angedeutet ist. Die erste Elektrode 5 und die zweite Elektrode 8 sind über Leitungen 10 bzw. 11 an ein Steuergerät 12 angeschlossen. Wird nun über dieses Steuergerät 12 ein Stromimpuls ausgelöst, so ergibt sich in dem in den Stromkreis eingeschalteten Leiterbahnsteg 3 eine Widerstandserwärmung und bei entsprechender Abstimmung der anliegenden Spannung auf Material und Querschnitt des Leiterbahnsteges 3 ein Widerstandsdurchbrennen des Leiterbahnsteges 3. Durch dieses Widerstandsdurchbrennen wird gemäß Figur 2 in den Leiterbahnsteg 3 ein Spalt 13 der Breite b eingebracht, wobei in Figur 2 die Anschlußfläche 1 ohne Wrapstift dargestellt ist.

Bei erfolgreichen Durchtrennungen von Leiterbahnstegen 3 aus Kupfer mit verzinnter Oberfläche und einem Querschnitt von 0,03 mm² wurden folgende Meßwerte ermittelt:

| | |
|---|---|
| Spannung | : 2,5-4,0 V |
| Strom | : ca. 350 A |
| Impulsdauer | : ca. 0,5-1,0 ms |
| Breite b des Spates 13 | : 0,1-0,3 mm |

Figur 1 zeigt in strichpunktierter Darstellung, daß die Anschlußfläche 1 über einen Leiterbahnsteg 14 mit einer der Anschlußfläche 2 gegenüberliegenden Anschlußfläche 15 verbunden sein kann. In diesem Fall muß dann anstelle des Leiterbahnsteges 3 der Leiterbahnsteg 14 durchgetrennt werden. Hierzu kann dann die zweite Elektrode 8 -wie es durch die Pfeile 21 angedeutet ist- um 180° um die erste Elektrode 5 gedreht werden. Es ist aber auch möglich die Anschlußfläche 15 mit Hilfe einer strichpunktiert dargestellten dritten Elektrode 16 zu kontaktieren. Um diese flexible Anpassung an die jeweilige Lage der zu durchtrennenden Leiterbahnstege 3 bzw. 14 zu ermöglichen, sind die erste Elektrode 5, die zweite Elektrode 8 und die dritte Elektrode 16 mechanisch unabhängig voneinander beweglich und dementsprechend unabhängig voneinander mit der zugeordneten Anschlußfläche bzw. dem zugeordneten Wrapstift kontaktierbar.

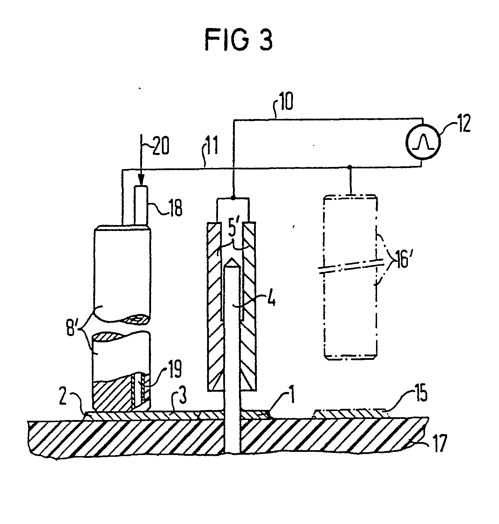

Figur 3 zeigt in stark vereinfachter schematischer Darstellung eine Einrichtung zum Widerstandsdurchbrennen von Leiterbahnstegen. Auf der Außenlage einer Leiterplatte 17 sind die Anschlußflächen 1 und 2 zu erkennen, die über den Leiterbahnsteg 3 elektrisch leitend miteinander verbunden sind. Eine strichpunktiert dargestellte Anschlußfläche 15 kann gemäß Figur 1 über einen Leiterbahnsteg 14 mit der Anschlußfläche 1 verbunden sein, wobei dieser Leiterbahnsteg 14 in der Darstellung nach Figur 3 bereits durchgetrennt sein soll und daher nicht mehr zu erkennen ist.

Die der ersten Anschlußfläche 1 zugeordnete erste Elektrode 5' ist als Zangenelektrode mit parallel öffnenden Backen ausgebildet, die entweder federnd gegen die Anschlußfläche 1 gedrückt werden kann oder einen in die Anschlußfläche 1 eingelöteten Wrapstift 4 zur Kontaktierung zu fassen vermag. Dabei sind beide Backen der ersten Elektrode 5' über die Leitung 10 an das Steuergerät 12 angeschlossen. Die der zweiten Anschlußfläche 2 zugeordnete zweite Elektrode 8' besitzt die Form eines Zylinders, der zur Kontaktierung federnd gegen die zweite Anschlußfläche 2 gedrückt werden kann. Die zweite Elektrode 8' ist dabei über die Leitung 11 an das Steuergerät 12 angeschlossen.

Ferner ist zu erkennen, daß in Längsrichtung ein Rohr 18 exzentrisch in die zweite Elektrode 8' eingesetzt ist. Dieses Rohr 18 bildet einen Zuführkanal 19 für eine durch einen Pfeil 20 angedeutete Schutzflüssigkeit. Die Schutzflüssigkeit 20, bei der es sich vorzugsweise um eine alkoholische Flüssigkeit handelt, wird vor dem Widerstandsdurchbrennen über den Zuführkanal 19 zugeführt, so daß sie beim Trennvorgang auftretende Metallpartikel binden kann und die freigelegte Oberfläche der Leiterplatte 17 gegen Niederschläge schützen kann.

Falls erforderlich, ist auch noch eine der Anschlußfläche 15 zugeordnete dritte Elektrode 16' vorhanden, die in Figur 3 strichpunktiert dargestellt ist. Die dritte Elektrode 16' ist dann ebenfalls als Zylinder ausgebildet und parallel zur zweiten Elektrode 8' über die Leitung 11 an das Steuergerät 12 angeschlossen.

Die Elektroden 5', 8' und 16' sind in unabhängig voneinander heb- und senkbaren Halterungen befestigt, die in Figur 3 nicht dargestellt sind. Dabei können beispielsweise die Elektroden 8' und 16' durch die Halterung der Elektrode 5' isoliert und längsverschieblich hindurchgeführt sein.

Das vorstehend beschriebene Widerstandsdurchbrennen von Leiterbahnstegen ist bei allen Kunststoffplatten mit metallischen Leitern mit und ohne zusätzliche Oberflächen einsetzbar.

**Patentansprüche**

1. Einrichtung zum Durchtrennen von Leiterbahnstegen (3, 14), die auf den Außenlagen von Leiterplatten (17) jeweils zwei Anschlußflächen (1, 2; 1, 15) elektrisch leitend miteinander verbinden, bei welcher die Leiterbahnstege (3, 14) über mindestens zwei an eine Stromquelle anschließbare und den Anschlußflächen (1, 2, 15) zugeordnete Elektroden (5, 8, 16; 5', 8', 16') durch elektrische Widerstandserwärmung vollständig durchgebrannt werden, dadurch gekennzeichnet, daß eine Elektrode (5; 5') als gegen eine Anschlußfläche (1) drückbare Zangenelektrode ausgebildet ist.

2. Einrichtung nach Anspruch 1, dadurch gekennzeichnet, daß eine Elektrode (8; 8') um die als Zangenelektrode ausgebildete Elektrode (5; 5') drehbar ist.

3. Einrichtung nach Anspruch 1 oder 2, dadurch gekennzeichnet, daß die Elektroden (5, 8, 16; 5', 8'; 16') mechanisch unabhängig voneinander heb- und senkbar sind.

4. Einrichtung nach einem der Ansprüche 1 bis 3, dadurch gekennzeichnet, daß in mindestens eine Elektrode (8') ein Zuführkanal (19) für eine Schutzflüssigkeit (20) eingebracht ist.

**Revendications**

1. Dispositif pour sectionner des barrettes formant voies conductrices conductrices (3, 14), qui relient de façon électriquement conductrice respectivement deux surfaces de raccordement (1, 2; 1, 15) entre elles, sur les couches extérieures de plaquettes à circuits imprimés (17), et dans lequel les barrettes formant voies conductrices conductrices (3; 14) peuvent être complètement sectionnées par brûlage par chauffage électrique par effet Joule au moyen de deux électrodes (5, 8, 16; 5', 8', 16') pouvant être raccordées à une source de courant et associées aux surfaces de raccordement (1, 2, 15), caractérisé par le fait qu'une électrode (5; 5') est réalisée à la manière d'une électrode en forme de pince pouvant être repoussée contre une surface de raccordement (1).

2. Dispositif suivant la revendication 1, caractérisé par le fait qu'une électrode (8; 8') peut pivoter autour de l'électrode (5; 5') réalisée à la manière d'une électrode en forme de pince.

3. Dispositif suivant la revendication 1 ou 2, caractérisé par le fait que les électrodes (5, 8, 16; 5', 8'; 16') peuvent être soulevées et abaissées mécaniquement indépendamment les unes des autres.

4. Dispositif suivant l'une des revendications 1 à 3, caractérisé par le fait qu'un canal (19) d'amenée d'un liquide de protection (20) est ménagé dans au moins une électrode (8').

**Claims**

1. Device for severing conductive paths (3, 14) which electroconductively interconnect in each case two contacting areas (1, 2: 1, 15) on the outer layers of printed circuit boards (17), in which the conductive paths (3, 14) are completely burnt through by electrical resistance heating by means of at least two electrodes (5, 8, 16; 5', 8', 16') which can be connected to a current source and are associated with the contacting areas (1, 2, 15), characterized in that one electrode (5; 5') is designed as a grip electrode which can be pressed against a contacting area (1).

2. Device according to Claim 1, characterized in that one electrode (8; 8') can be rotated about the electrode (5; 5') designed as grip electrode.

3. Device according to Claim 1 or 2, characterized in that the electrodes (5, 8, 16; 5', 8'; 16') can be mechanically raised and lowered independently of one another.

4. Device according to one of Claims 1 to 3, characterized in that a supply channel (19) for a protective fluid (20) is provided in at least one electrode (8').

# FIG 1

# FIG 2

## FIG 3